(19) Europäisches Patentamt / European Patent Office / Office européen des brevets

(11) **EP 4 632 408 A1**

(12) **EUROPEAN PATENT APPLICATION**
published in accordance with Art. 153(4) EPC

(43) Date of publication:
**15.10.2025 Bulletin 2025/42**

(21) Application number: **23900289.2**

(22) Date of filing: **26.09.2023**

(51) International Patent Classification (IPC):
*G01R 31/392* (2019.01)   *G01R 31/00* (2006.01)
*H01M 10/44* (2006.01)   *H01M 10/48* (2006.01)
*H02J 7/00* (2006.01)

(52) Cooperative Patent Classification (CPC):
**G01R 31/00; G01R 31/392; H01M 10/44;**
**H01M 10/48; H02J 7/00; Y02E 60/10**

(86) International application number:
**PCT/JP2023/034948**

(87) International publication number:
**WO 2024/122165 (13.06.2024 Gazette 2024/24)**

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**KH MA MD TN**

(30) Priority: **08.12.2022 JP 2022196135**

(71) Applicant: **Hitachi, Ltd.**
**Tokyo 100-8280 (JP)**

(72) Inventor: **UEDA, Suguru**
**Tokyo 100-8280 (JP)**

(74) Representative: **Mewburn Ellis LLP**
**Aurora Building**
**Counterslip**
**Bristol BS1 6BX (GB)**

(54) **DIAGNOSIS DEVICE FOR SECONDARY BATTERY AND DIAGNOSIS METHOD FOR SECONDARY BATTERY**

(57)   Provided is a diagnosis device capable of appropriately diagnosing progress of deterioration of an electrode in a secondary battery. A diagnosis device (100) for a secondary battery (200) that diagnoses an internal state of an electrode that constitutes the secondary battery (200). The diagnosis device includes a diagnosis unit (120) configured to diagnose the internal state using a relaxation time distribution. The relaxation time distribution is expressed by using a DC voltage value before starting charging at a constant voltage or a DC voltage value before starting discharging at the constant voltage, a DC voltage value at the time of charging or a DC voltage value at the time of discharging at the constant voltage, and a change with time of a DC current value at the time of charging at the constant voltage or a change with time of a DC current value at the time of discharging at the constant voltage, by energization of a DC current to the secondary battery (200). Alternatively, the relaxation time distribution is expressed by using a DC current value before completion of charging at a constant current or a DC current value before completion of discharging at the constant current, and a change with time of a DC voltage value after completion of charging at the constant current or a change with time of a DC voltage value after completion of discharging at the constant current, by energization of the DC current to the secondary battery (200).

[FIG. 1]

## Description

Technical Field

The present disclosure relates to a diagnosis device for a secondary battery and a diagnosis method for a secondary battery.

Background Art

In recent years, efforts have been made to efficiently utilize energy by using a secondary battery such as a lithium ion secondary battery as a power source for power storage of a smart house or a power source to be mounted on a ship, an aircraft, a vehicle, or the like. However, a characteristic of a secondary battery deteriorates with use. Accordingly, to continuously use a product on which the secondary battery is mounted in a stable manner, it is preferable to appropriately determine a deterioration state of the secondary battery.

In a smartphone, a vehicle, or the like on which a secondary battery is mounted, a rapid charging method of charging the secondary battery with a large current can be adopted for the purpose of shortening a charging time. On the other hand, rapid charging rapidly deteriorates the characteristics of the secondary battery. Accordingly, in order to determine a deterioration state of the secondary battery, it is preferable to appropriately evaluate the deterioration of characteristics of the secondary battery generated by the rapid charging.

The deterioration of characteristics of the secondary battery is derived from, for example, deterioration of an active material contained in an electrode of the secondary battery. The active material is one of the materials that constitute an electrode of the secondary battery. The active material plays a role of promoting a charge/discharge reaction of the secondary battery by storing and releasing lithium ions. For example, in the case of a lithium ion secondary battery, a charging reaction proceeds in such a manner that lithium ions are released from a positive electrode active material at the time of charging the secondary battery, and the released lithium ions are stored in a negative electrode active material. A discharging reaction follows the reverse process.

In the Abstract of PTL 1, there is a description that "An analysis device includes a battery state analysis unit that detects a change of state of a constituent member of a battery based on a change in a peak of a relaxation time in a predetermined frequency **band"**.

Citation List

Patent Literature

PTL 1: WO 2017/179266 A

Summary of Invention

Technical Problem

In the technique described in PTL 1, a relaxation time distribution is determined using an alternating current impedance method (paragraph 0073). However, in the AC impedance method, although details will be described later, it is difficult to apply an AC current having a large amplitude. The deterioration of the electrodes constituting the secondary battery is particularly likely to proceed when used at a large current. For this reason, in the technique described in PTL 1 in which it is difficult to use an alternating current having a large amplitude, it is not possible to appropriately diagnose the progress of deterioration of the secondary battery.

An object of the present disclosure is to provide a diagnosis device for a secondary battery and a diagnosis method for a secondary battery capable of appropriately diagnosing progress of deterioration of an electrode in a secondary battery.

Solution to Problem

A diagnosis device for a secondary battery of this disclosure is a diagnosis device for a secondary battery that diagnoses an internal state of an electrode that constitutes the secondary battery. The diagnosis device includes a diagnosis unit configured to diagnose the internal state using a relaxation time distribution. The relaxation time distribution is expressed by using a DC voltage value before starting charging at a constant voltage or a DC voltage value before starting discharging at the constant voltage, a DC voltage value at the time of charging or a DC voltage value at the time of discharging at the constant voltage, and a change with time of a DC current value at the time of charging at the constant voltage or a change with time of a DC current value at the time of discharging at the constant voltage, by energization of a DC current to the secondary battery. Alternatively, the relaxation time distribution is expressed by using a DC current value before completion of charging at a constant current or a DC current value before completion of discharging at the constant current, and a change with time of a DC voltage value after completion of charging at the constant current or a change with time of a DC voltage value after completion of discharging at the constant current, by energization of the DC current to the secondary battery. Other solutions to problems will be described later in embodiments for carrying out the present invention.

Advantageous Effects of Invention

To overcome the above-mentioned drawbacks, it is an object of this disclosure to provide a diagnosis device for a secondary battery and a diagnosis method for a secondary battery capable of appropriately diagnosing the progress of deterioration of an electrode in a secondary battery.

Brief Description of Drawings

[FIG. 1] FIG. 1 is a block diagram illustrating a diagnosis device for this disclosure.
[FIG. 2] FIG. 2 is a schematic view of an electrode that a normal secondary battery includes.
[FIG. 3] FIG. 3 is a schematic view of an electrode that an abnormal secondary battery includes.
[FIG. 4] FIG. 4 is a block diagram illustrating the hardware configuration of the diagnosis device for this disclosure.
[FIG. 5] FIG. 5 is a flowchart illustrating a diagnosis method for this disclosure.
[FIG. 6] FIG. 6 is a graph illustrating a measurement result of a change in a DC current value with time when charging is performed as a constant voltage in an example 1.
[FIG. 7] FIG. 7 is a graph illustrating a result of spectrum indicating a relaxation time distribution obtained using the measurement result in FIG. 6.
[FIG. 8] FIG. 8 is a photograph illustrating a result obtained by disassembling a battery that uses a DC current value of 25A and by observing a surface state of a negative electrode with naked eyes.
[FIG. 9] FIG. 9 is a photograph illustrating a result obtained by disassembling a battery that uses a DC current value of 100A and by observing a surface state of a negative electrode with naked eyes.
[FIG. 10] FIG. 10 is a graph illustrating a result by obtaining spectrum with respect to a battery charged or discharged at a temperature of 25°C in an example 2.
[FIG. 11] FIG. 11 is a graph illustrating a result by obtaining spectrum with respect to a battery charged or discharged at a temperature of 5°C in the example 2.
[FIG. 12] FIG. 12 is a graph illustrating a measurement result of a change in a DC current value with time when a constant voltage is charged in an example 3.
[FIG. 13] FIG. 13 is a graph illustrating a result of spectrum indicating a relaxation time distribution obtained using the measurement result in FIG. 12.

Description of Embodiments

Hereinafter, modes for carrying out this disclosure (also referred to as embodiments) are described with reference to drawings. In the description of one embodiment made hereinafter, the description of another embodiment applicable to one embodiment is also performed when necessary. This disclosure is not limited to one embodiment described below, and different embodiments are combined with each other, and the embodiments can be arbitrary modified within a range that advantageous effects of this disclosure are not significantly impaired. Further, the same members are denoted by identical symbols, and repeated descriptions will be omitted. Further, components having the same function are denoted by the same name. The illustrated contents are merely illustrated as schematic examples. For the sake of convenience of illustration, within a range that advantageous effects of this disclosure are not significantly impaired, the configurations may be changed from the actual configuration, or the illustration of some members may be omitted or modified between the drawings. Further, in the same embodiment, it is not always necessary that the embodiment includes all components.

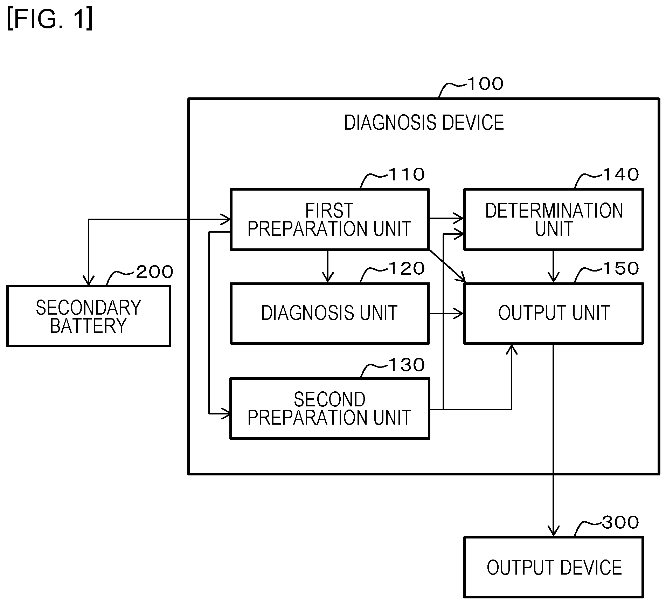

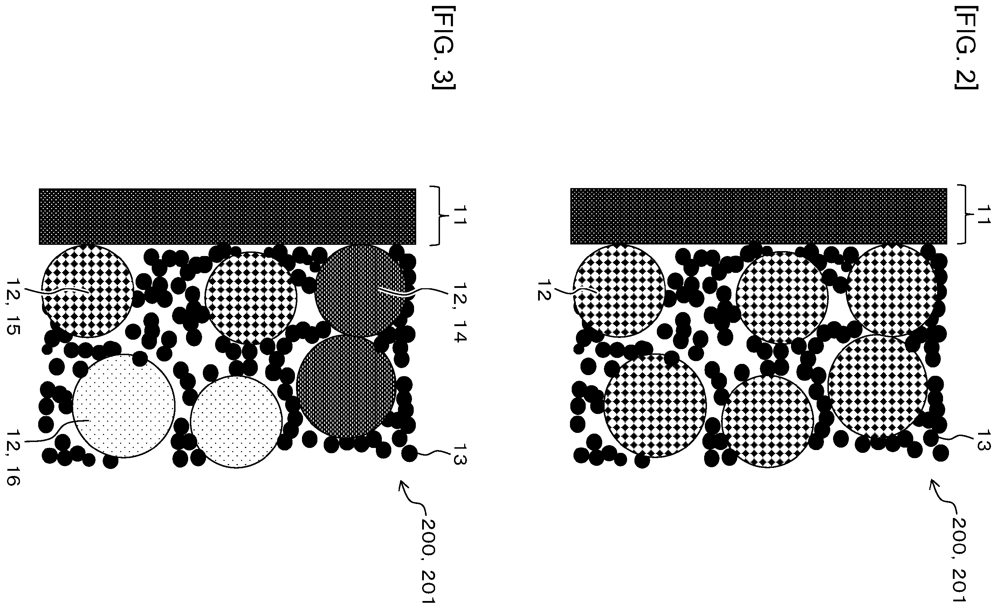

FIG. 1 is a block diagram illustrating the diagnosis device 100 according to this disclosure. The diagnosis device 100 is a diagnosis device for a secondary battery 2000 that diagnoses the internal state of an electrode 201 (FIG. 2). An electrode 201 constitutes the secondary battery 200.

The secondary battery 200 is, for example, a lithium ion secondary battery, a lead storage battery, or the like, and in the description made hereinafter, as an example, the secondary battery 200 is a lithium ion secondary battery. The number of secondary batteries 200 may be one or plural. The secondary battery 200 is, for example, a battery cell, a battery pack, a battery system, a battery module, or the like. Among these components, the battery pack, the battery system, and the battery module each include a plurality of battery cells.

FIG. 2 is a schematic view of the electrode 201 that a normal secondary battery 200 includes. In this specification, the term "normal" means, for example, an unused state immediately before factory shipment or immediately after factory shipment. That is, the term "normal" means a state where an active material 12 is not deteriorated. The secondary battery 200 includes an electrode 201 that forms a positive electrode and an electrode that forms a negative electrode. The electrode 201 is configured such that, for example, the active material 12 (for example, a positive electrode active material or a negative electrode active material) and a conductive auxiliary agent 13 are supported on a current collecting foil 11. The electrode 201 has the structure where the inside of the electrode 201 is filled with the active material 12.

FIG. 3 is a schematic view of an electrode 201 that an abnormal secondary battery 200 includes. When the secondary battery 200 is used with a large current value as in the case of rapid charging, active materials 12 that have different deterioration states are generated in the electrode 201 due to the expansion and the contraction of the active materials 12, Joule heat generation and the like. For example, in the example illustrated in FIG. 3, the active materials 12 include active materials 15 in which the deterioration minimally progresses, active materials 14 in which the deterioration slightly progresses, and active materials 16 in which the deterioration remarkably progresses. That is, the electrode 201 of the secondary battery 200 is non-uniformly deteriorated corresponding to a use method such as rapid charging.

When the active materials 12 deteriorate, the deterioration of characteristics of the secondary battery 200 occurs. For example, an internal resistance of the secondary battery 200 is increased or an amount of electricity (battery capacity) that can be stored in or released from the secondary battery 200 is lowered. Accordingly, in order to accurately grasp the deterioration of characteristics of the secondary battery 200, it is preferable to evaluate the nonuniformity of the deterioration state inside the electrode 201. That is, it is preferable to evaluate the deterioration degree of the electrode 201 with high accuracy.

In another embodiment, although the details will be described later, local energization (power concentration) may occur on a surface of the electrode 201 due to the structure of the secondary battery 200, a using state of the secondary battery 200, and the like. Accordingly, in the same manner as the above-mentioned non-uniform deterioration of the active materials 15, the electrode 201 may be non-uniformly deteriorated. In view of the above, it is preferable that a phenomenon relating to local energization on the surface of the electrode 201 can also be evaluated.

In still another embodiment, there is a possibility that metallic lithium precipitates on the surface of the electrode 201 due to the use of the secondary battery 200 at a low temperature, for example. The precipitation of metallic lithium significantly deteriorates the battery characteristics of the secondary battery 200. Therefore, it is preferable that a phenomenon relating to the precipitation of metallic lithium on the electrode 201 can also be evaluated.

As described in these respective embodiments, various phenomenons occur inside the electrode 201, and as a result of such phenomenons, the deterioration of the electrode 201 may progress. According to studies made by the inventors of the present invention, it has been found that the progress of deterioration of the electrode 201 can be evaluated with high accuracy by using a relaxation time distribution (for example, spectrum) indicating an internal state of the electrode 201. Accordingly, the diagnosis device 100 of the present disclosure diagnoses the internal state of the electrode 201 using such a relaxation time distribution.

Returning to FIG. 1, the diagnosis device 100 includes a first preparation unit 110, a diagnosis unit 120, a second preparation unit 130, a determination unit 140, and an output unit 150.

The first preparation unit 110 acquires data necessary for preparing a relaxation time distribution by controlling charging or discharging (charging and discharging) of the secondary battery 200, and prepares the relaxation time distribution. With the provision of the first preparation unit 110, it is possible to prepare a relaxation time distribution capable of diagnosing the internal state of the electrode 201. The prepared relaxation time distribution is transmitted to the diagnosis unit 120, the second preparation unit 130, and the determination unit 140 described later.

In the example of the present disclosure, the relaxation time distribution is expressed in a graph where an axis of abscissas represents the relaxation time and an axis of ordinates represents a strength of a spectrum indicating the relaxation time distribution (DRT). However, the expressing form is not limited to such a graph. For example, the relaxation time distribution may be expressed in a tabular form in place of a graph. The reciprocal of the relaxation time is the frequency, and the relaxation time matches the measurement time for obtaining the relaxation time distribution. Further, the relaxation time distribution does not need to be prepared by controlling charging and discharging of the secondary battery 200. For example, a relaxation time distribution stored in a server (not illustrated in the drawing) via a network (not illustrated in the drawing) may be acquired. Further, the relaxation time distribution does not need to be newly prepared, and a relaxation time distribution that is stored in advance in the diagnosis device 100 may be used.

As has been described above, the relaxation time distribution indicates the internal state of the electrode 201 that constitute the secondary battery 200. The relaxation time distribution is expressed by using: a DC voltage value before starting charging at a constant voltage or a DC voltage value before starting discharging at a constant voltage; a DC voltage value at the time of charging or a DC voltage value at the time of discharging at a constant voltage, and a change with time of a DC current value at the time of charging at a constant voltage or a change with time of a DC current value at the time of discharging at a constant voltage. Charging or discharging at a constant voltage is performed by energization of a DC current to the secondary battery 200.

Alternatively, the relaxation time distribution is expressed by using a DC current value before completion of charging at a constant current or a DC current value before completion of discharging at a constant current, and a change with time of a DC voltage value after completion of charging at a constant current or a change with time of a DC voltage value after completion of discharging at a constant current. Charging or discharging at a constant current is also performed by energization of a DC current to the secondary battery 200.

In the above-mentioned processing, it is preferred that "before starting charging" and "before completion of discharging" respectively mean "immediately before starting charging" and "immediately before completion of discharging".

In one embodiment, in a case where the first preparation unit 110 uses, for example, a change with time of a DC current value at the time of charging or discharging at a constant voltage, the first preparation unit 110 can prepare the relaxation time distribution as follows.

The first preparation unit 110 measures a voltage value immediately before starting charging at a constant voltage in the secondary battery 200, and respective changes with time of a DC voltage value, a DC current value, and a temperature of the secondary battery 200 from a point of time t1 to a point of time t2 at which charging is completed after starting of constant voltage charging. The term "constant voltage charging" (charging at a constant voltage) means a charging method where the secondary battery 200 is charged while being held at a constant DC voltage value. The time from the point of time t1 to the point of time t2 is not particularly limited, but it is preferred that the time is 1 minute or more, and it is more preferred 10 minutes or more, for example. When the secondary battery 200 includes a plurality of battery cells, the first preparation unit 110 measures a change with time of a DC voltage value, a change with time of a DC current value, and a change with time of a temperature of each battery cell. The measured data are stored in a recording unit not illustrated in the drawing.

The first preparation unit 110 prepares and acquires the above-mentioned relaxation time distribution using a predetermined relationship where a DC voltage value before starting charging at the constant voltage or a DC voltage value before starting discharging at the constant voltage, a DC voltage value at the time of charging or at the time of discharging at the constant voltage, a change with time of a DC current value at the time of charging at a constant voltage or a change with time of a DC current value at the time of discharging at the constant voltage are associated with each other. With use of such predetermined relationship, the relaxation time distribution can be prepared from the measured values.

In an example of the embodiment, the predetermined relationship is expressed by the following expression (1). However, the predetermined relationship may be changed depending on a matter to be associated when necessary.
[Math 1]

$$\rho\,(\tau)=\mathcal{L}^{-1}\,(I\,(t)\,/\,\Delta V)\quad\ldots\text{expression (1)}$$

In the expression, $\rho\,(\tau)$ represents a relaxation time distribution (for example, a spectrum), $\Delta V$ represents a difference between a DC voltage value before starting constant voltage charging and a DC voltage value at the time of charging at constant voltage, and I (t) represents a change with time of a DC current value at time of charging at a constant voltage. The symbol $L^{-1}$ (reciprocal of L expressed in cursive) indicates an inverse Laplace transform for I (t)/$\Delta V$.

In another embodiment, when the first preparation unit 110 uses, for example, a change with time in a DC voltage value after completion of charging at a constant current or after completion of discharging at a constant current, the first preparation unit 110 can prepare the relaxation time distribution as follows.

The first preparation unit 110 measures a DC current value of the secondary battery 210 immediately before constant current charging or constant current discharging is completed, and measures changes with time of a DC voltage value, a DC current value and a temperature of the secondary battery 200 from a point of time t3 that constant current charging or constant current discharging is completed to a point of time t4 when the constant current charging or constant current discharging is completed. "Constant current charging" (charging at a constant current) and "constant current discharging" (discharging at a constant current) are methods for charging or discharging the secondary battery 200 at a constant DC current value respectively. Although the time from the point of time t3 to the point of time t4 is not particularly limited, it is preferred that the time is 1 minute or more, and it is more preferred that the time is 10 minutes or more, for example.

The first preparation unit 110 acquires the above-mentioned relaxation time distribution using a predetermined relationship where a DC current value before the completion of charging at a constant current or a DC current value before the completion of discharging at a constant current is associated with a change with time in a DC voltage value after the completion of charging at a constant current or a change with time in a DC voltage value after the completion of discharging at a constant current. With use of such predetermined relationship, the relaxation time distribution can be prepared from the measured values. In an example of another embodiment, the predetermined relationship is expressed by the following formula (2). However, the predetermined relationship may be changed depending on a matter to be associated when necessary.

[Math 2]

$$\rho V (\tau) = \mathcal{L}^{-1} (V (t) / I 0) \quad \dots \text{expression (2)}$$

$\rho V (\tau)$ represents a relaxation time distribution (for example, a spectrum) obtained from a change with time of a DC voltage value, I0 represents a DC current value before the completion of the constant current charging or before the completion of the constant current discharging, and V (t) represents a change with time of the DC voltage value after the completion of the constant current charging or after the completion of the constant current discharging. Symbol $L^{-1}$ (reciprocal of L expressed in cursive) indicates an inverse Laplace transform for V (t)/I0.

With respect to still another embodiment, the relaxation time distribution ($\rho V (\tau)$) in the above expression (2) is equivalent to the relaxation time distribution ($\rho (\tau)$) in the above expression (1). In accordance with Ohm's law, the relationship expressed by the following expression (3) exists between $\rho (\tau)$ and $\rho V (\tau)$.

[Math 3]

$$\int d \tau \cdot \rho (\tau) / (s \tau + 1) = 1 / (s \int d \tau \cdot \rho V (\tau) / (s \tau + 1))$$

$$\dots \text{expression (3)}$$

In the expression, s represents a complex number. The expression (3) means that $\rho (\tau)$ is obtained from $\rho V (\tau)$. That is, it is understood that $\rho (\tau)$ and $\rho V (\tau)$ are mutually convertible amounts, and when one is obtained, the other is naturally obtained. Based on such understanding, in examples 1 to 3 described later, a diagnosis method using $\rho (\tau)$ will be described by exemplifying $\rho (\tau)$ which is a relaxation time distribution obtained from a DC current value. The results of examples 1 to 3 are also established with respect to the relaxation time distribution $\rho V (\tau)$ obtained from a DC voltage value.

Returning to the above-mentioned one embodiment, the diagnosis unit 120 illustrated in FIG. 1 diagnoses an internal state of the electrode 201 (FIG. 2) using the relaxation time distribution described later. The diagnosis unit 120 diagnoses the internal state of the electrode 201 using the shape of a spectrum that indicates the relaxation time distribution with respect to the secondary battery 200 to be inspected. By diagnosing the internal state of the electrode 201 based on the shape of the spectrum, the internal state can be intuitively diagnosed. The shape of the spectrum may be outputted to an output device 300.

The diagnosis unit 120 diagnoses the internal state of the electrode 201 (FIG. 2) using at least one information out of the number of peaks included in the spectrum, the positions of the peaks, or the half-value widths of the peaks. Although details will be described later, these pieces of information are different between the normal electrode 201 and the abnormal electrode 201. Accordingly, by using these information, it is possible to diagnose whether the electrode 201 is normal or abnormal. The diagnosis result is transmitted to the output unit 150.

When a differential between a target spectrum that indicates the relaxation time distribution with respect to the secondary battery 200 to be inspected and a predetermined reference spectrum exceeds a predetermined range, the diagnosis unit 120 diagnoses that the state of the secondary battery 200 to be inspected is a predetermined state. By comparing the target spectrum with the reference spectrum and by performing the diagnosis based on the differential, accuracy of diagnosis can be objectively ensured. The predetermined range can be determined by a preliminary experiment or the like depending on what state the predetermined state is set to.

In the example of the present disclosure, the reference spectrum is a spectrum measured with respect to a normal secondary battery 200, and the predetermined state is an abnormal state. By performing such processing, using the reference spectrum measured with respect to the normal secondary battery 200 as the reference, the diagnosis unit 120 can determine that the secondary battery 200 having the target spectrum that deviates from the reference spectrum is abnormal.

In another embodiment, the secondary battery 200 is a battery pack, a battery system, or a battery module that includes a plurality of battery cells (unit cells). With respect to at least one battery cell out of the plurality of battery cells included in the secondary battery 200, the diagnosis unit 120 diagnoses an internal state of the electrode 201 (FIG. 2) that constitute such battery cell. As a result, the diagnosis unit 120 can diagnoses which secondary battery out of a plurality of battery cells is subjected to the deterioration of the electrode 201. Further, the diagnosis unit 120 can detect a difference in deterioration state among the plurality of battery cells.

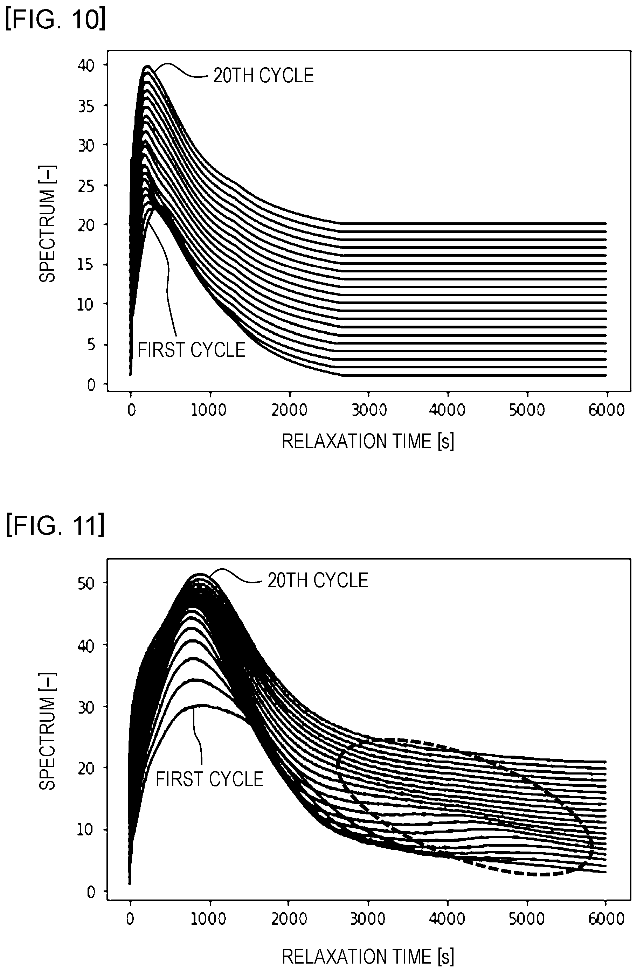

As described above, the relaxation time distribution is a spectrum illustrated in the graph where the relaxation time is taken on an axis of abscissas and the relaxation time distribution is taken on an axis of ordinates. In this embodiment, with respect to the relaxation time, a first relaxation time range having a predetermined range, and a second relaxation time range having a predetermined range that is a predetermined range different from the first relaxation time range are defined. The relaxation time distribution preferably includes a relaxation time distribution that is continuously formed by a relaxation time that includes the first relaxation time range and the second relaxation time range. For example, in FIG. 10 described later, the first relaxation time ranges from 0 seconds to 600 seconds, and the second relaxation time ranges from 3000 seconds to 6000 seconds.

The diagnosis unit 120 diagnoses different phenomena related to the internal state between the relaxation time distribution formed within the first relaxation time range and the relaxation time distribution formed within the second relaxation time range. As a result, different phenomena can be diagnosed by focusing on different relaxation time ranges in the continuously measured spectrum, so that the time and effort for diagnosis can be reduced.

The different phenomenon is, for example, at least one state selected from local energization of the surface of the electrode 201 (FIG. 2), the precipitation of metallic lithium on the electrode 201, and a deterioration degree of the electrode 201. Accordingly, the presence or absence of these states can be diagnosed by evaluating the spectrum in different relaxation time ranges. Among these states, the local energization on the surface of the electrode 201 (FIG. 2) is evaluated in example 1 described later. The deposition of metallic lithium on the electrode 201 is evaluated in example 2 described later. The deterioration degree of the electrode 201 is evaluated in example 3 described later.

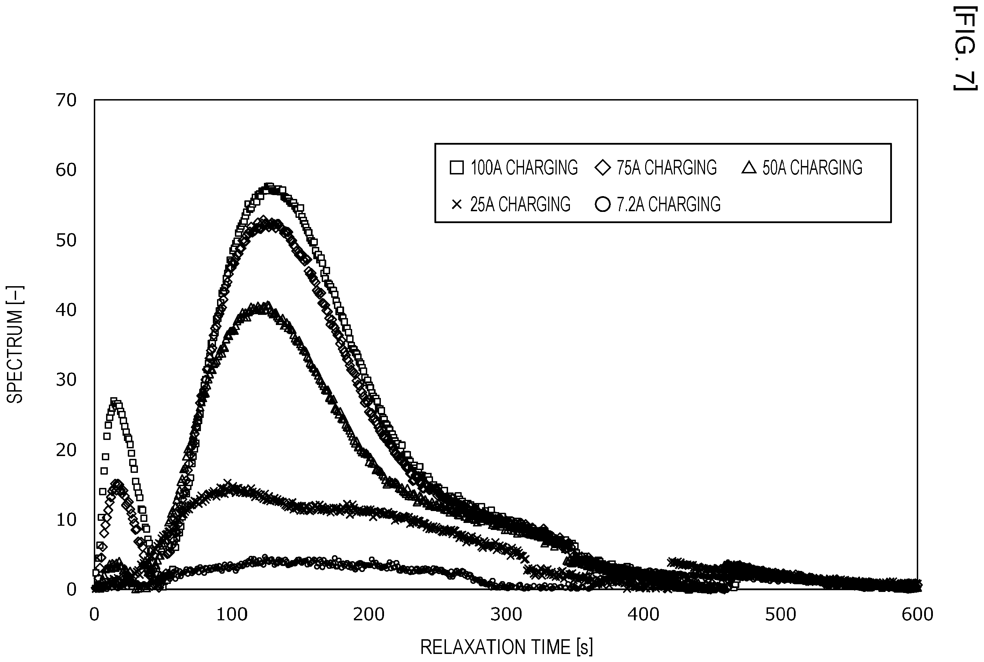

For example, the first relaxation time range is, for example, a relaxation time range taken on an axis of abscissas in FIG. 7 described later, and the second relaxation time range is, for example, a relaxation time range taken on an axis of abscissas in FIG. 10 described later. By setting the first relaxation time range and the second relaxation time range in this manner, it is possible to detect local energization on the surface of the electrode 201 (FIG. 2) at a relaxation time of 0 seconds to 600 seconds illustrated in FIG. 7, and it is possible to detect precipitation of metallic lithium on the electrode 201 at a relaxation time of 3000 seconds to 6000 seconds illustrated in FIG. 10. By including the relaxation time distribution continuously formed with the relaxation time that includes the first relaxation time range and the second relaxation time range, these phenomena can be continuously detected and hence, time and effort for diagnosis can be reduced.

The diagnosis unit 120 may repeatedly perform diagnosis on the same secondary battery 200 a plurality of times. In this case, the diagnosis is preferably performed under different conditions. For example, the first-time diagnosis can be performed based on the relaxation time distribution obtained by performing constant voltage charging, and the second-time diagnosis can be performed based on the relaxation time distribution obtained by performing constant current discharging. By performing the diagnosis in this manner, the diagnosis results obtained under different conditions can be compared and hence, diagnosis accuracy can be improved.

The second preparation unit 130 prepares an assumed spectrum when the temperature at which the secondary battery is used is assumed to be a predetermined temperature from a change with time in a temperature of the secondary battery 200 after the starting or the completion of the charging or the discharging and the shape of the target spectrum. The spectrum indicating the relaxation time distribution indicates the internal state of the electrode 201. The internal resistance of the electrode 201 changes depending on the temperature of the secondary battery 200 and hence, the spectrum may also be different. In view of the above, by preparing an assumed spectrum when the secondary battery 200 is the secondary battery 200 used at a predetermined temperature from the shape of the target spectrum, it is possible to diagnose the internal state by matching the conditions as much as possible.

The relaxation time distribution used in the second preparation unit 130 is received from the first preparation unit 110, for example. The assumed spectrum prepared by the second preparation unit 130 is transmitted to the determination unit 140 and the output unit 150. Further, the preparation of the assumed spectrum by the second preparation unit 130 can be performed by deforming the shape of the target spectrum such that a differential between the change with time of a temperature and the predetermined temperature becomes **0**, for example. The target spectrum deformed in this manner is the assumed spectrum.

The determination unit 140 determines an operation condition of the secondary battery 200 to be inspected so that a differential between the above target spectrum and the normal spectrum indicating the relaxation time distribution with respect to the normal secondary battery 200 falls within a predetermined range. The allowable operation condition of the secondary battery 200 differs corresponding to the deterioration degree of the secondary battery 200. Further, as described above, the shape of the spectrum can also change corresponding to the deterioration degree. For example, when an excessive current flows, the number of peaks tends to increase in the spectrum indicating the relaxation time distribution. In view of the above, according to the determination unit 140, an operation condition under which the target spectrum can be acquired can be determined such that a differential between the target spectrum and the normal spectrum falls within a predetermined range (that is, in order to bring the target spectrum close to the normal spectrum). As a result, the secondary battery 200 to be inspected can be operated within a range of allowable operation condition corresponding to the deterioration degree.

The operation condition includes at least one of a DC current value, a DC voltage value, or a temperature at the time of performing at least one of charging or discharging of the secondary battery 200. The operation condition includes such values and hence, the spectrum of the secondary battery 200 can be brought close to the spectrum of the normal secondary battery 200. For example, a temperature control for lowering a temperature can be performed, for example, by driving a cooling mechanism (not illustrated in the drawing, for example, a fan) that can be included in the secondary battery 200.

The determination unit 140 prepares the above target spectrum while changing the above operation condition, and determines the operation condition of the secondary battery 200 by searching for an operation condition under which the differential falls within the above predetermined range. In this manner, the operation condition can be determined.

A target spectrum used in the determination unit 140 is received from the first preparation unit 110 and the second preparation unit 130. In a case where a temperature is taken into consideration as described above, the assumed spectrum received from the second preparation unit 130 is used. On the other hand, in a case where a temperature is not taken into consideration, a target spectrum received from the first preparation unit 110 is used. The operation condition determined by the determination unit 140 is transmitted to the output unit 150.

The output unit 150 outputs a target spectrum acquired by the first preparation unit 110, a diagnosis result obtained by a diagnosis performed by the diagnosis unit 120, an assumed spectrum prepared by the second preparation unit 130, an operation condition determined by the determination unit 140, and the like to the output device 300. The output device 300 is, for example, a display device such as a monitor or a display, a printing device such as a printer, or the like.

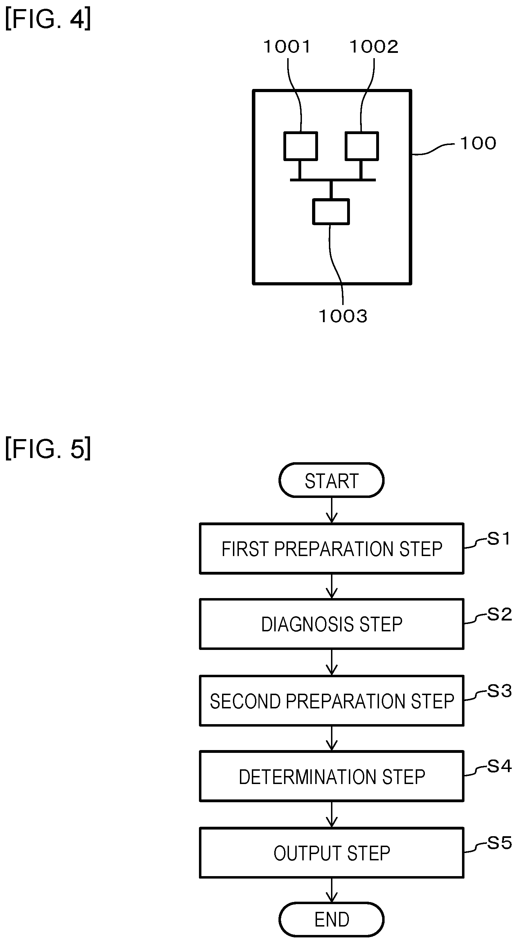

FIG. 4 is a block diagram illustrating the hardware configuration of the diagnosis device 100 of this disclosure. The diagnosis device 100 includes, for example, a central processing unit (CPU) 1001, a random access memory (RAM) 1002, a read only memory (ROM) 1003, and the like. The diagnosis device 100 is embodied by developing a predetermined control program (for example, a diagnosis method) stored in the ROM 1003 in the RAM 1002 and executing the program by the CPU 1001.

FIG. 5 is a flowchart illustrating a diagnosis method for this disclosure. The diagnosis method of the present disclosure can be performed by the above diagnosis device 100.

The diagnosis method of the present disclosure is a diagnosis method of diagnosing the secondary battery 200 for diagnosing an internal state of the electrode 201 (FIG. 2) that constitutes the secondary battery 200 (FIG. 1). The diagnosis method for the present disclosure includes a first preparation step S1, a diagnosis step **S2,** a second preparation step **S3,** a determination step **S4,** and an output step **S5.** The first preparation step S1 can be performed by the first preparation unit 110 (FIG. 1). The diagnosis step S2 can be performed by the diagnosis unit 120 (FIG. 1). The second preparation step S3 can be performed by the second preparation unit 130 (FIG. 1). The determination step S4 can be performed by the determination unit 140 (FIG. 1). The output step S5 can be performed by the output unit 150 (FIG. 1).

The first preparation step S1 is a step of preparing a relaxation time distribution by controlling charging or discharging of the secondary battery 200 (FIG. 1). The relaxation time distribution is, as described above, expressed by using: a DC voltage value before starting charging at a constant voltage or a DC voltage value before starting discharging at a constant voltage; a DC voltage value at the time of charging or a DC voltage value at the time of discharging at a constant voltage, and a change with time of a DC current value at the time of charging at a constant voltage or a change with time of a DC current value at the time of discharging at a constant voltage, by energization of a DC current to the secondary battery 200.

Alternatively, the relaxation time distribution is expressed by using: a DC current value before completion of charging at a constant current or a DC current value before completion of discharging at a constant current; and a change with time of a DC voltage value after completion of charging at a constant current or a change with time of a DC voltage value after completion of discharging at a constant current, by energization of a DC current to the secondary battery 200.

The diagnosis step S2 is a step of diagnosing an internal state of the electrode 201 using the relaxation time distribution. The relaxation time distribution is, for example, the relaxation time distribution acquired in the first preparation step S1.

The second preparation step S3 is a step where the shape of the assumed spectrum when a temperature at which the secondary battery 200 is used is assumed as a predetermined temperature is formed based on a change with time and the shape of the target spectrum. In this embodiment, the change with time is a change with time in the temperature of the secondary battery 200 after the start or completion of the charging or discharging. In this embodiment, the target spectrum is a spectrum indicating a relaxation time distribution of the secondary battery 200 to be inspected.

The determination step S4 is a step of determining the operation condition of the secondary battery 200 to be inspected such that a differential between the target spectrum and the normal spectrum indicating the relaxation time distribution with respect to the normal secondary battery 200 (FIG. 1) falls within a predetermined range.

The output step S5 is a step of outputting, to the output device 300, each spectrum such as the spectrum acquired in the acquisition step S1, and the state (the deterioration degree or the like) of the secondary battery 200 diagnosed based on the spectrum.

According to the diagnosis device 100 and the diagnosis method of the present disclosure described above (hereinafter, the diagnosis device 100 and the diagnosis method being collectively and simply referred to as the "present disclosure" when appropriate), it is possible to appropriately diagnose the progress of deterioration of the electrode. The present disclosure can be used for any inspection of the secondary battery 200. For example, the manufacturer or the like of the secondary battery 200 acquires in advance the relaxation time distribution at the time of factory shipment (normal spectrum) that is the spectrum of the normal secondary battery 200. Then, the present disclosure is applied to any battery product that includes the secondary battery 200 (consumer products, industrial products, ships, aircrafts, vehicles, and the like). For example, an electric device may include the diagnosis device 100, or the diagnosis method of the present disclosure is used with respect to an electric product. Accordingly, the progress of deterioration of the electrode 201 generated, for example, by the use of an electrical appliance can be detected by the present disclosure using a normal spectrum acquired in advance.

Hereinafter, the present disclosure will be described more specifically with reference to examples 1 to 3. In the examples, it is verified whether the relaxation time distribution (spectrum) is appropriately obtained by the diagnosis device 100 of the present disclosure. In the examples 1 to 3, the secondary battery 200 was mainly charged. Charging and discharging can be considered in the same manner only by reversing the occlusion and the release of lithium ions to and from active materials. Accordingly, the results of the following example 1 to 3 can be similarly applied to a case where the secondary battery 200 is discharged.

First, as the example 1, in the verification, a cylindrical lithium ion secondary battery having a battery capacity of 7Ah (hereinafter, simply referred to as a "battery" when appropriate) was used as the secondary battery 200. Positive active materials of the battery are $LiNiMnCoO_2$, and negative active materials are graphite. When a large current is applied to the battery, a reaction distribution is formed on the electrode of the battery due to the influence of temperature distribution or the like in the battery. It was evaluated whether the formation of such a reaction distribution could be detected by using a spectrum.

In the measurement, five batteries were prepared, and these batteries were rapidly charged at respective DC current values of 7.2A, 25A, 50A, 75A, and 100A. At this stage of the operation, an initial voltage of the battery was adjusted to 3.75 V, the charging of the battery was switched to constant voltage charging at a timing that the battery voltage reached 4.1 V, and a change with time of a DC current value at the time of constant voltage charging (during constant voltage charging) was measured for about 30 minutes. The measurement was performed by leaving the battery in a thermostatic chamber where a temperature was held at 25°C. The DC voltage value during the constant voltage charging was 4.1 V.

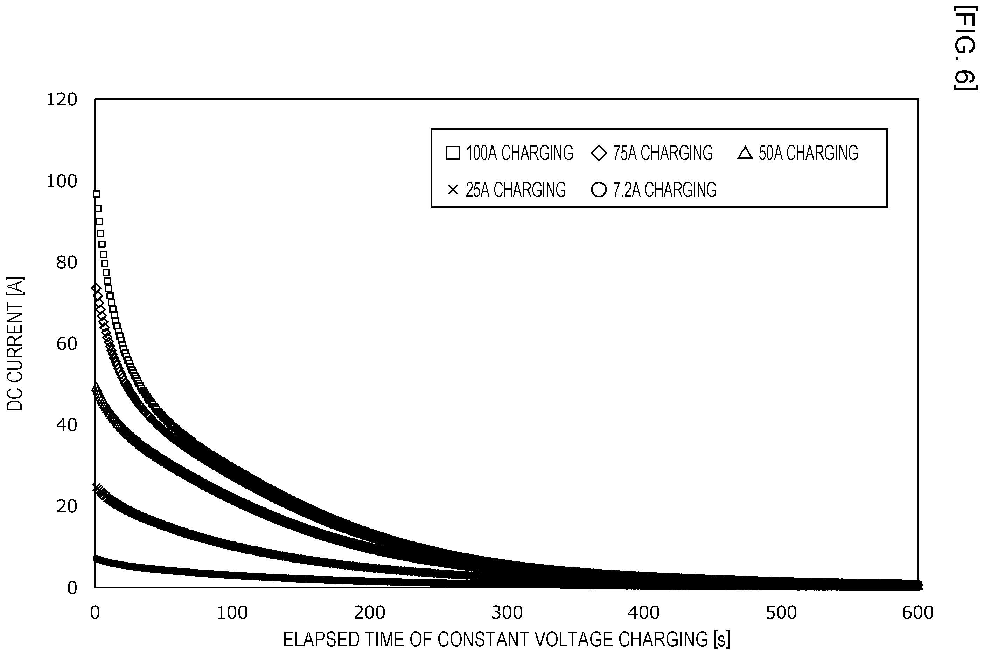

FIG. 6 is a graph illustrating a measurement result of a change with time in a DC current value when a constant voltage is charged in the embodiment 1. In FIG. 6, square plots indicate charging performed at 100A, diamond plots indicate charging performed at 75A, triangle plots indicate charging performed at 50A, cross plots indicate charging performed at 25A, and circle plots indicate charging performed at 7.2A. These marks have substantially the same meaning in FIG. 7 illustrated later.

FIG. 7 is a graph illustrating a result of spectrum indicating a relaxation time distribution obtained using the measurement result illustrated in FIG. 6. The relaxation time distribution was obtained using the above expression (1). The inverse Laplace transform in the expression (1) was analytically obtained by solving an integral equation. By solving the integral equation, noises caused by energization of a DC current was reduced.

Looking at the spectra at 7.2A (circles) and 25A (crosses), the spectra generally have a single peak. For example, at 7.2A, a peak exists only approximately between 100 seconds to 200 seconds. At 25A, the peak exists only at a portion of about 100 seconds. However, looking at the spectra at 50A (triangle), 75A (diamond), and 100A (square), one peak exists in each of the relaxation time between 0 second to 100 seconds and between 100 seconds to 200 seconds. That is, a plurality of peaks exist.

As described above, the number of peaks in the spectrum represents the number of reaction processes that progress in the battery. Accordingly, the result illustrated in FIG. 7 indicates that at least two or more kinds of reaction processes exist in mixture in the battery during rapid charging performed at 50A or more. When a large current is applied to the battery, the magnitude of a value of a current that flows on the electrode becomes non-uniform by being affected by the temperature distribution or the like generated in the battery. For example, in a region on the electrode where a temperature is locally increased, a reaction resistance of the battery is decreased and hence, a large current locally flows. Such a phenomenon may be also referred to as the current concentration hereinafter.

The cylindrical battery used in the test performed this time has the winding structure where an electrode is wound about an axis. With such a structure, Joule heat generated at the time of charging and discharging is liable to be confined in the axis center portion and hence, and a temperature on an axis center side is liable to be locally increased at the time of charging and discharging. That is, it is considered that two types of peaks on the spectrum at the time of performing rapid charging of 50A or more indicate a reaction process due to the current concentration generated on a battery axis center side and a reaction process in a region other than the axis center side.

It is considered that, in the electrode of the battery in which the current concentration occurs, a large current locally flows on the electrode and hence, the electrode deterioration is likely to locally progress. Accordingly, in order to clarify the relationship between the number of peaks of the spectrum indicating the spectrum and the current concentration, a deterioration test was further performed using another two cylindrical batteries (both cylindrical batteries being prepared in the same preparation method).

In the deterioration test, one battery was deteriorated by repeatedly performing charging and discharging at a current value of 25A, and the other battery was deteriorated by repeatedly performing charging and discharging at a current value of 100A. In the deterioration test performed at a current value of 25A, a pattern that a current of 25A is applied for 72 seconds and the battery is stopped for 72 seconds was repeated. In the deterioration test performed at a current value of 100A, a pattern that a current of 100A is applied for 18 seconds and the battery is stopped for 199 seconds was repeated. The reason why the time that electricity is supplied differs between two deterioration tests is to make an amount of power applied to the battery during the deterioration test agree with each other between the 25A test and the 100A test.

As a result of the deterioration test, it was confirmed that the capacity of the battery that was deteriorated at 100A was decreased by about 10% as compared with the battery that was deteriorated at 25A. That is, the battery deteriorated at 100A was further deteriorated compared to the battery deteriorated at 25A.

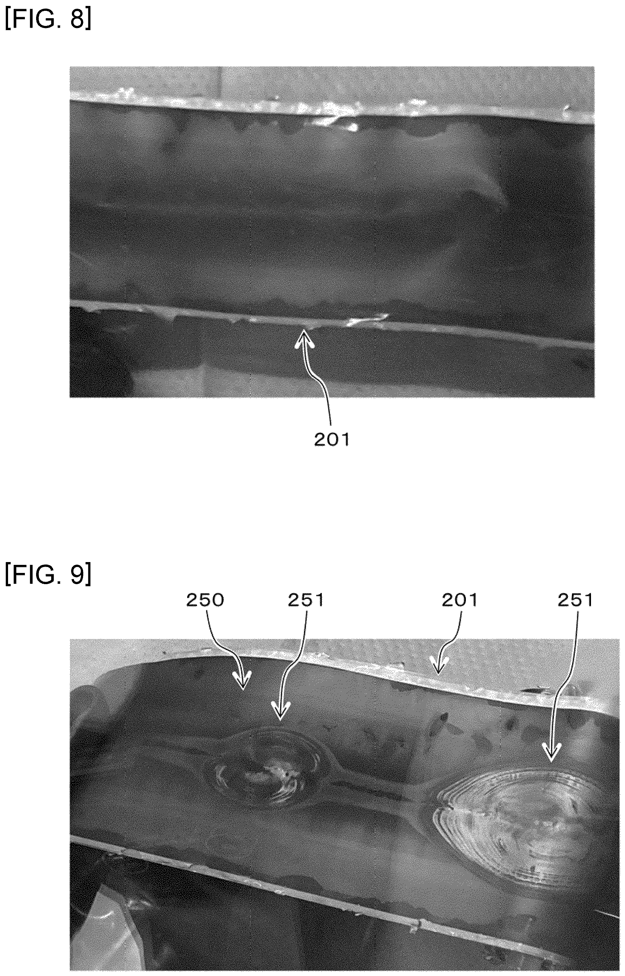

FIG. 8 is a photograph illustrating a result obtained by disassembling a battery (secondary battery) that was used at a DC current value of 25A and by observing a surface state of a negative electrode (electrode) with naked eyes. FIG. 9 is a photograph illustrating a result obtained by disassembling a battery (secondary battery) that was used at a DC current value of 100A and by observing an about surface state of a negative electrode with naked eyes. In each of FIGS. 8 and 9, the left and right direction in the drawing is the winding direction of the electrode.

As illustrated in FIG. 8, the electrode 201 used at 25A maintained a uniform state as observed with naked eyes, and no abnormal portion was observed. However, as illustrated in FIG. 9, on the surface of the electrode 201 used at 100A besides a non-discolored region 250, a partially colored region 251 was also confirmed. According to a state where the electrode 201 is non-uniformly deteriorated can be confirmed. This state suggests the current concentration occurred in the battery deteriorated at 100A, and is consistent with the calculation result of the spectrum illustrated in FIG. 7 above. Also from this point of view, it can be understood that the spectrum of the battery is obtained with high accuracy according to the present disclosure.

It must be emphasized that the above analysis results cannot be obtained by the method of PTL 1 described above. An alternating current impedance method (EIS) described in PTL 1 is a method for diagnosing an internal state of a battery in a non-destructive manner. In this method, an alternating current or an alternating voltage is input to a battery, and a current-voltage response of the battery to the alternating current or the alternating voltage is measured. In analyzing the measurement result by the EIS, a spectral method (DRT) is used. The DRT is a method of converting the frequency dependency of the impedance acquired by the EIS into a continuous function of the relaxation time. By using this continuous function of the relaxation time, the state in the battery can be analyzed in a non-destructive manner with high accuracy. The continuous function of the relaxation time may also be referred to as a relaxation spectrum.

In the example of the present disclosure, a large current of, for example, about 100A (not being limited to this value) is applied to the battery in order to acquire the spectrum (relaxation spectrum). However, when the same large current is applied in the EIS, a battery voltage reaches an overvoltage when an AC current is applied. As a result, the measurement itself of current-voltage characteristics of the battery becomes impossible. Accordingly, the spectrum illustrated in FIG. 7 can be calculated only in a case where the present disclosure is applied. As a result, the present disclosure is more advantageous than the technique described in PTL 1.

In the technique described in PTL 1, in order to apply AC currents and AC voltages in various frequency bands to a battery, the battery is removed from a battery product. Then, impedance characteristics are measured using a dedicated impedance measuring device. Accordingly, the operation takes large man-hours to acquire the spectrum. Further, with the technique described in PTL 1, it is not also possible to evaluate a state of a battery real-time in a state where the battery product is being used. Accordingly, in the technique described in PTL 1, the rapid characteristic deterioration of the battery, an abnormality occurrence situation of the battery, a sign of abnormality occurrence, and the like are likely to be overlooked.

However, the present disclosure can be directly applied to DC current and DC voltage data that are standardly acquired relating to battery controllers of battery products in general. Therefore, according to the present disclosure, the spectrum can be calculated without removing a battery from a battery product. As a **result,** the operation man-hours required to acquire the spectrum can be reduced. Further, the rapid characteristic deterioration of a battery, an abnormality occurrence state of the battery, a sign of abnormality occurrence, and the like can be easily detected.

In example 1 described above, according to the present disclosure, non-uniform deterioration of an electrode due to current concentration was detected. On the other hand, the present disclosure is also applicable to the detection of various battery abnormalities besides the detection of the current concentration. In order to verify the application of the present disclosure to the detection of various battery abnormalities, as example 2, an example is described where a precipitation phenomenon of metal lithium occurring at the time of using a battery at a low temperature is detected.

In example 2, a small card-type battery (secondary battery 200) having a battery capacity of 33 mAh was used. A positive electrode active material of this battery was $LiNiMnCoO_2$, a negative electrode active material was graphite, and a $LiPF_6$ electrolytic solution adjusted to 1M with ethylene carbonate and dimethyl carbonate was used as a nonaqueous electrolytic solution. The use ratio of ethylene carbonate and dimethyl carbonate is 1:2 in volume ratio.

In the test, two card-type batteries were prepared, and one battery was placed in a thermostatic chamber adjusted to 5°C, and the other battery was placed in a thermostatic chamber adjusted to 25°C, and the test was performed. During the test, a series of cycles of rapidly charging from 2.7 V to 4.2 V at a DC current value of 66 mA, discharging at a constant current (DC current) of 66 mA to 2.7 V after a pause of 30 minutes, and providing a pause of 30 minutes again was repeated 20 times. In the above-mentioned operation, at the time of performing rapid charging, the charging was switched to constant voltage charging at the timing that a battery voltage reached 4.2 V, the constant voltage charging was continued for about 90 minutes, and a change of a DC current with time during such a time was obtained. A DC voltage value immediately before the constant voltage charging is 4.2 V.

FIG. 10 illustrates a result of obtaining spectra with respect to the battery (secondary battery 200) charged and discharged at a temperature of 25°C in example 2. In FIG. 10 and FIG. 11 described later, spectra acquired in the respective charge-discharge cycles are indicated side by side in an axis of coordinates. The spectrum close to the origin of the axis of coordinates indicates an analysis result of a first cycle, and the spectrum remotest from the origin in the direction of the axis of coordinates indicates spectrum of the 20th cycle.

Looking at the test result at a temperature of 25°C illustrated in FIG. 10, a single peak structure can be confirmed in a portion of approximately 0 to 1000 seconds in the obtained spectra. It is found that this structure does not change even when the number of cycles is repeated, and the state in the battery does not change even when charging and discharging are repeated almost 20 times.

FIG. 11 illustrates a result of obtaining spectra with respect to the battery (secondary battery 200) charged and discharged at a temperature of 5°C in example 2. Looking at the test result at a temperature of 5°C illustrated in FIG. 11, two peaks are formed in both of about 1000 seconds and about 3000 to 5000 seconds in the spectra. In particular, to focus on a peak (a portion surrounded by a broken line) in a region where the relaxation time is long, it can be confirmed that the position at which the peak appears changes as the number of cycles is increased.

When a precipitation phenomenon of metal lithium occurs in a battery, an amount of metal lithium precipitated on an electrode is gradually increased with the increase of the number of cycles. As a result, **a** change with time of the peak position in the portion surrounded by the broken line is considered to indicate a process of forming the such a lithium metal phase. In particular, when metal lithium is deposited on an electrode surface and a layer of metal lithium becomes thick, lithium ions in a non-aqueous electrolytic solution are stably occluded in the layer. Accordingly, the battery reaction is completed as in the case where lithium ions are occluded in the active material. Then, it is considered that the layer of metallic lithium becomes thicker as the number of cycles is increased, and an occlusion rate of lithium ions is increased resulting in a shorter relaxation time. Although not illustrated in the drawing, in the same manner as in example 1 described above, when the battery during the cycle test was disassembled and a surface state of a negative electrode was analyzed, it was confirmed that metallic lithium was deposited on an electrode surface.

As illustrated in example 2, the present disclosure can also be applied to the detection of the precipitation behavior of metallic lithium.

Next, as example 3, the present disclosure can also be applied to diagnosis of the degree of deterioration (deterioration degree) of a battery. In example 3, the result of applying the present disclosure to two types of batteries having different deterioration degrees that are obtained in example 1 is described.

In example 3, a DC current of 3.6A was applied to each of two types of batteries having different deterioration degrees, and after a battery voltage value reached 4.2 V by charging, constant voltage charging was performed for about 30 minutes, and a change with time in a DC current was measured. A DC voltage value during the constant voltage charging was 4.2V.

In example 1 described above, spectra were analyzed by applying different DC currents to two batteries having the same deterioration degree. On the other hand, in example 3, spectra were acquired by applying DC current values of the same magnitude to the same type of batteries having different deterioration degrees. That is, in example 3, the same test conditions were set as example 1 except that the deterioration degrees of two batteries were different, and it was verified whether the deterioration degrees of the respective batteries could be appropriately evaluated by the present disclosure.

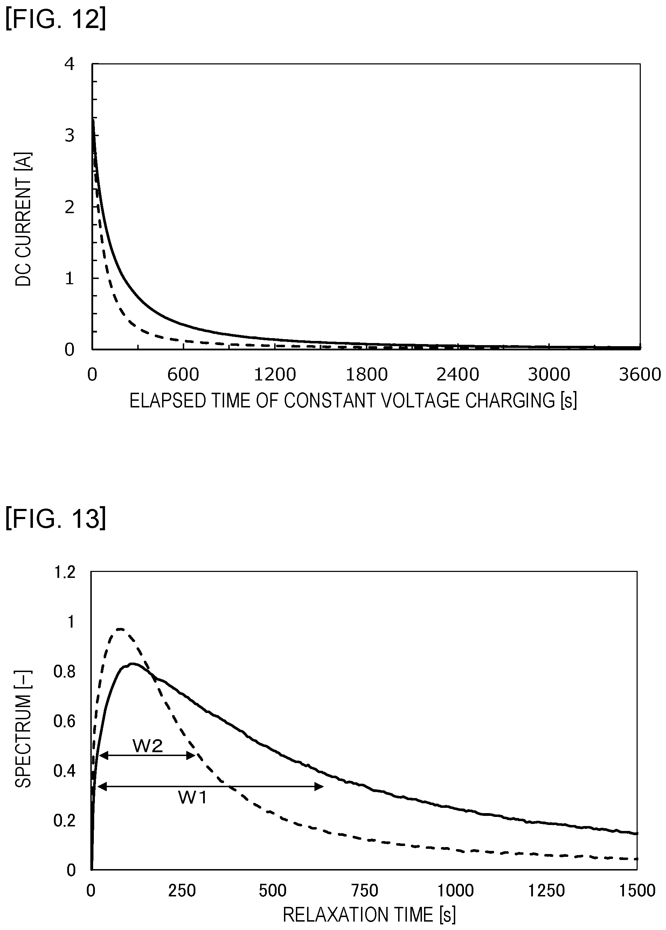

FIG. 12 is a graph illustrating a measurement result of a change in a DC current value with time when charging is performed at a constant voltage in the example 3. In FIG. 12, a broken line indicates a measurement result of a battery having a low deterioration degree (for example, an unused battery), and a solid line indicates a measurement result of a battery having a high deterioration degree. As illustrated in FIG. 12, in a battery having a small deterioration degree indicated by a broken line, a DC current value was decreased immediately after the starting of constant voltage charging as compared with a battery having a large deterioration degree indicated by a solid line.

FIG. 13 is a graph illustrating a result of spectra indicating a relaxation time distribution obtained using the measurement result illustrated in FIG. 12. As illustrated in FIG. 13, it was confirmed that the obtained spectra had a single peak at a site with a relaxation time of 0 to 250 seconds in both cases regardless of a magnitude of the deterioration degree. However, the difference existed between half-value widths W1, W2 of peaks depending on the magnitude of the deterioration degree. The half-value width W1 is, in a battery having a large deterioration degree indicated by a solid line, a time that exists within 1/2 or more using a maximum value of the peak as the reference. The half-value width W2 is, in a battery having a small deterioration degree indicated by a broken line, a time that exists within 1/2 or more using a maximum value of the peak as the reference. It was confirmed that the half-value width W1 of the battery having a large deterioration degree indicated by the solid line was increased as compared with the half-value width W2 of the battery having a small deterioration degree indicated by the broken line. That is, it is safe to say that the larger the deterioration degree, the larger the half-value width becomes.

The spectrum corresponds to a histogram representing a relaxation time contributing to a battery reaction. For example, in a battery having the small deterioration degree indicated by the solid line, the spectrum value has a peak structure within a range where the relaxation time is about 50 to 250 seconds, and the spectrum value is rapidly attenuated in other regions. This means that, in the case of the battery having a small deterioration degree, the relaxation time of the battery reaction is about 50 to 250 seconds. Similarly, in the case of a battery having a large deterioration degree, the relaxation time of the battery reaction is about 50 to 750 seconds.

A relaxation time of a battery is proportional to a magnitude of a reaction resistance of the battery. Accordingly, when the deterioration degree in the battery is uniform, the reaction resistance in the battery is also uniform, and the relaxation time of the battery indicates a constant value. On the other hand, when the deterioration degree in the battery is non-uniform, the reaction resistance in the battery is also non-uniform, and the relaxation time of the battery varies with a constant width. That is, the wider the distribution of the relaxation time of the battery reaction, the more non-uniformly the inside of the battery is deteriorated. This means that the larger the half-value width W1, W2 of the spectrum, the more non-uniformly an internal state of the battery is deteriorated.

This result well agrees with the results of disassembling of the battery illustrated in FIG. 8 and FIG. **9.** As shown in FIG. 8 and FIG. **9,** while a state of the electrode of the battery having the small deterioration degree (the battery that was deteriorated by 25A, FIG.8) was uniform, a state of the battery having the large deterioration degree (the battery that was deteriorated by 100A, FIG. 9) was non-uniformly deteriorated on the electrode. As described above, the nonuniformity of the deterioration state in the battery correlates well with the half-value width W1, W2 of the spectrum. Accordingly, the non-uniformity of deterioration can be estimated from the spectrum. That is, according to the present disclosure, the present disclosure can also be applied to the diagnosis of the deterioration degree of the battery according to the magnitude of the half-value width.

Reference Signs List

| | |
|---|---|
| 100 | diagnosis device |
| 110 | first preparation unit |
| 120 | diagnosis unit |
| 130 | second preparation unit |
| 140 | determination unit |
| 150 | output unit |
| 200 | secondary battery |
| 210 | secondary battery |
| 300 | output device |
| S1 | first preparation step |
| S2 | diagnosis step |
| S3 | second preparation step |
| S4 | determination step |
| S5 | output step |
| W1 | half-value width |
| W2 | half-value width |

**Claims**

1. A diagnosis device for a secondary battery that diagnoses an internal state of an electrode that constitutes the secondary battery, the diagnosis device comprising
a diagnosis unit configured to diagnose the internal state using a relaxation time distribution, wherein

the relaxation time distribution is expressed by using a DC voltage value before starting charging at a constant voltage or a DC voltage value before starting discharging at the constant voltage, a DC voltage value at the time of charging or a DC voltage value at the time of discharging at the constant voltage, and a change with time of a DC current value at the time of charging at the constant voltage or a change with time of a DC current value at the time of discharging at the constant voltage, by energization of a DC current to the secondary battery, or
the relaxation time distribution is expressed by using a DC current value before completion of charging at a constant current or a DC current value before completion of discharging at the constant current, and a change with time of a DC voltage value after completion of charging at the constant current or a change with time of a DC voltage value after completion of discharging at the constant current, by energization of the DC current to the secondary battery.

2. The diagnosis device for a secondary battery according to claim **1,** wherein
the diagnosis unit diagnoses the internal state of the electrode using a shape of a spectrum that indicates the relaxation time distribution with respect to the secondary battery to be inspected.

3. The diagnosis device for a secondary battery according to claim **2,** wherein
the diagnosis unit diagnoses the internal state of the electrode using at least one information out of

    a number of peaks included in the spectrum,
    positions of the peaks, or
    half-value widths of the peaks.

4. The diagnosis device for a secondary battery according to claim **1,** wherein
the diagnosis unit diagnoses that a state of the secondary battery to be inspected is a predetermined state when a differential between a target spectrum that indicates the relaxation time distribution with respect to the secondary battery to be inspected and a predetermined reference spectrum exceeds a predetermined range.

5. The diagnosis device for a secondary battery according to claim 4, wherein

    the reference spectrum is a spectrum measured with respect to the normal secondary battery, and
    the predetermined state is an abnormal state.

6. The diagnosis device for a secondary battery according to claim 1, further comprising
a second preparation unit that prepares a shape of an assumed spectrum when a temperature at which the secondary battery is used is assumed to be a predetermined temperature from a change with time in a temperature of the secondary battery after starting or completion of the charging or the discharging and a shape of a target spectrum that indicates the relaxation time distribution with respect to the secondary battery to be inspected.

7. The diagnosis device for a secondary battery according to claim 1, further comprising
a first preparation unit that prepares the relaxation time distribution by controlling the charging or the discharging to the secondary battery.

8. The diagnosis device for a secondary battery according to claim **7,** wherein
the first preparation unit prepares the relaxation time distribution using:

    a predetermined relationship where a DC voltage value before starting charging at the constant voltage or a DC voltage value before starting discharging at the constant voltage, or a DC voltage value at the time of charging or a DC voltage value at the time of discharging at the constant voltage, or a change with time of a DC current value at the time of charging at the constant voltage or a change with time of a DC current value at the time of discharging at the constant voltage are associated with each other, or
    a predetermined relationship where a DC current value before completion of charging at the constant current or a DC current value before completion of discharging at the constant current is associated with a change with time of a DC voltage value after completion of charging with the constant current or a change with time of a DC voltage value after completion of discharging with the constant current.

9. The diagnosis device for a secondary battery according to claim **7,** further comprising
a determination unit that determines an operation condition of the secondary battery to be inspected such that a differential between a target spectrum indicating the relaxation time distribution with respect to the secondary battery to be inspected and a normal spectrum indicating the relaxation time distribution with respect to the normal secondary battery falls within a predetermined range.

10. The diagnosis device for a secondary battery according to claim **9,** wherein
the operation condition includes at least one of a DC current value, a DC voltage value, or a temperature at the time of performing at least one of charging or discharging of the secondary battery.

11. The diagnosis device for a secondary battery according to claim **9,** wherein
the determination unit prepares the target spectrum while changing the operation condition, and determines the operation condition of the secondary battery by searching for an operation condition under which the differential falls within the predetermined range.

12. The diagnosis device for a secondary battery according to claim 1, wherein

the secondary battery is a battery pack, a battery system, or a battery module including a plurality of battery cells, and

the diagnosis unit diagnoses, with respect to at least one of the battery cells out of the plurality of battery cells included in the secondary battery, an internal state of an electrode that constitutes the battery cell.

13. The diagnosis device for a secondary battery according to claim 1, wherein

the relaxation time distribution comprises a relaxation time distribution continuously formed with relaxation times including a first relaxation time range and a second relaxation time range,

the diagnosis unit diagnoses different phenomena related to the internal state based on a relaxation time distribution formed in the first relaxation time range and a relaxation time distribution formed in the second relaxation time range.

14. A secondary battery diagnosis method for diagnosing an internal state of an electrode constituting a secondary battery, wherein
the secondary battery diagnosis method comprises a diagnosis step of diagnosing the internal state by using a relaxation time distribution, and

the relaxation time distribution is expressed by using a DC voltage value before starting charging at a constant voltage or a DC voltage value before starting discharging at the constant voltage, a DC voltage value at the time of charging or discharging at the constant voltage, or a change with time of a DC current value at the time of charging at the constant voltage or a change with time of a DC current value at the time of discharging at the constant voltage, by energization of a DC current to the secondary battery, or

the relaxation time distribution is expressed by using a DC current value before completion of charging with a constant current or a DC current value before completion of discharging with the constant current, or a change with time of a DC voltage value after completion of charging with the constant current or a change with time of a DC voltage value after completion of discharging with the constant current, by energization of the DC current to the secondary battery.

[FIG. 1]

[FIG. 2]

[FIG. 3]

[FIG. 4]

[FIG. 5]

[FIG. 6]

Legend:
- □ 100A CHARGING
- ◇ 75A CHARGING
- △ 50A CHARGING
- × 25A CHARGING
- ○ 7.2A CHARGING

Y-axis: DC CURRENT [A] (0, 20, 40, 60, 80, 100, 120)

X-axis: ELAPSED TIME OF CONSTANT VOLTAGE CHARGING [s] (0, 100, 200, 300, 400, 500, 600)

[FIG. 7]

[FIG. 8]

201

[FIG. 9]

250   251   201   251

EP 4 632 408 A1

[FIG. 10]

[FIG. 11]

21

[FIG. 12]

[FIG. 13]

## INTERNATIONAL SEARCH REPORT

| International application No. |
| --- |
| **PCT/JP2023/034948** |

| A. | CLASSIFICATION OF SUBJECT MATTER |
| --- | --- |

*G01R 31/392*(2019.01)i; *G01R 31/00*(2006.01)i; *H01M 10/44*(2006.01)i; *H01M 10/48*(2006.01)i; *H02J 7/00*(2006.01)i
FI:   G01R31/392; H01M10/48 P; H01M10/44 P; G01R31/00; H02J7/00 Q

According to International Patent Classification (IPC) or to both national classification and IPC

| B. | FIELDS SEARCHED |
| --- | --- |

Minimum documentation searched (classification system followed by classification symbols)

G01R31/392; G01R31/00; H01M10/44; H01M10/48; H02J7/00

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| Y | WO 2017/179266 A1 (SONY CORP.) 19 October 2017 (2017-10-19)<br>paragraphs [0014]-[0200], fig. 1-15 | 1-14 |
| Y | US 2015/0081237 A1 (SEEO, INC.) 19 March 2015 (2015-03-19)<br>paragraphs [0027]-[0103], fig. 1-13 | 1-14 |
| Y | WO 2022/171993 A1 (HORIBA MIRA LIMITED) 18 August 2022 (2022-08-18)<br>page 1, line 5 to page 30, line 37, fig. 1-14 | 1-14 |
| Y | CN 109270463 A (NANJING FORESTRY UNIVERSITY) 25 January 2019 (2019-01-25)<br>paragraphs [0004]-[0108], fig. 1-16 | 1-14 |
| A | JP 2014-196943 A (MITSUBISHI ELECTRIC CORP.) 16 October 2014 (2014-10-16)<br>entire text, all drawings | 1-14 |
| A | WO 2017/026149 A1 (SONY CORP.) 16 February 2017 (2017-02-16)<br>entire text, all drawings | 1-14 |

☐ Further documents are listed in the continuation of Box C.          ☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **28 November 2023** | **12 December 2023** |

| Name and mailing address of the ISA/JP | Authorized officer |
| --- | --- |
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

## INTERNATIONAL SEARCH REPORT
### Information on patent family members

International application No.

**PCT/JP2023/034948**

| Patent document cited in search report | | | Publication date (day/month/year) | Patent family member(s) | | | Publication date (day/month/year) |
|---|---|---|---|---|---|---|---|
| WO | 2017/179266 | A1 | 19 October 2017 | US 2019/0023131 A1 paragraphs [0034]-[0244], fig. 1-15 | | | |
| US | 2015/0081237 | A1 | 19 March 2015 | CN 104462632 A paragraphs [0027]-[0079], fig. 1-13 | | | |
| WO | 2022/171993 | A1 | 18 August 2022 | GB 2603894 A page 1, line 5 to page 49, line 7, fig. 1-14 | | | |
| CN | 109270463 | A | 25 January 2019 | (Family: none) | | | |
| JP | 2014-196943 | A | 16 October 2014 | (Family: none) | | | |
| WO | 2017/026149 | A1 | 16 February 2017 | US 2018/0269540 A1 entire text, all drawings EP 3285326 A1 CN 107534194 A | | | |

Form PCT/ISA/210 (patent family annex) (January 2015)

**EP 4 632 408 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2017179266 A